# EUROPEAN PATENT SPECIFICATION

(11) **EP 0 362 961 B1**
(45) Date of publication and mention of the grant of the patent: **16.02.1994**
(21) Application number: 89202497.7
(22) Date of filing: 03.10.1989
(51) Int. Cl.: H01L 29/784, H01L 29/66

(54) **A method of operating a MOS-structure and MOS-structure therefor**
Verfahren zum Betrieb einer MOS-Struktur und MOS-Struktur dafür
Procédé pour le fonctionnement d'une structure MOS et structure MOS dans ce but

(30) Priority: 03.10.1988 NL 8802423
(43) Date of publication of application: 11.04.1990
(73) Proprietor: INTERUNIVERSITAIR MICROELEKTRONICA CENTRUM VZW, 3030 Leuven-Heverlee (BE)
(72) Inventor: Tack, Marnix Roger Anna, B-1820 Grimbergen (BE)
(74) Representative: Land, Addick Adrianus Gosling

(56) References cited:
- EP-A- 0 114 061
- EP-A- 0 207 619
- IEEE ELECTRON DEVICE LETTERS, vol. EDL-4, no. 8, August 1983, pages 269-271, IEEE; B.-Y. TSAUR et al.: "Fully isolated lateral bipolar-MOS transistors fabricated in zone-melting-recrystallized Si films on SiO2"
- IEEE ELECTRON DEVICE LETTERS, vol. EDL-4, no. 6, June 1983, pages 193-195, IEEE; M. RODDER et al.: "Silicon-on-insulator bipolar transistors"
- IEEE TRANSACTIONS ON ELECTRON DEVICES, vol. ED-32, no. 2, February 1985, pages 258-281, IEEE; S.D.S. MALHI et al.: "Characteristics and three-dimensional integration of MOSFET's in small-grain LPCVD polycrystalline silicon"

## Description

### Background of the invention

The present invention relates to the field of MOS-structures, more particular to a SOI-nMOS (Silicon-on-Insulator-n type-Metal-Oxide-Semiconductor) structure.

### Prior art

In the international search relating to the Dutch patent of this application the following prior art references were cited:
- EP-A-0207619 (FUJITSU);
- IEEE Electron Device Letters, vol. EDL-4, No. 8, August 1983 (New York, U.S.A.), pages 269-271, B.Y. Tsaur et al.;
- IEEE Electron Device Letters, vol. EDL-4, No. 6, June 1983 (New York, U.S.A.), pages 269-271 M. Rodder et al.;
- EP-A-0114061 (HITACHI);
- IEEE Transactions on Electron Devices, vol. ED-32, No. 2, February 1985 (New York, U.S.A) pages 193-195, S.D.S. Mahli et al.

Between the first filing date (October 3, 1988) of the Dutch patent application and the present filing date, the following publications of which the content is to be seen as inserted here and which are annexed, were disclosed by one or more of the present inventors:
- The Multistable Charge Controlled Memory effect in SOI-transistors at Low Temperature, by M. Tack et al.
- "Solid State Devices", Elsevier Science Publishers B.V. (North-Holland), page 549, 1988, by D. Wouters et al.
- Proc. 1988, page 78, IEEE SOS/SOI Technology Workshop, 1988.

### Summary of the invention

The present invention relates to a method of operating SOI-FET-structure, including a conducting back gate, a back oxide provided thereon, a silicon film provided thereon of one conductivity type provided with a channel region in which semiconductor material of the other conductivity type is provided, an oxide layer provided on said region of the other conductivity type, and a conducting top gate provided on said oxide layer.

Such method is known from EP-A-0207619, disclosing a SOI-structure providing a FET and a capacitor together such as to increase the operating speed of the transistor in dynamic memory cells.

It is an object of the present invention to provide a novel method of operating a SOI-FET-structure, e.g. as a novel and elegantly simple memory element.

The method according to the present invention is characterized by influencing the amount of charge in the channel region such that the threshold voltage of said FET is adjusted and maintaining such channel charge condition during a certain time period by cooling the the SOI-FET-structure such that a multistable operating condition of said FET is obtained.

As such, it is known from EP-A-114061 to cool a semiconductor structure which in this case is a CMOS type semiconductor integrated circuit (not SOI).

Further advantages, characteristics and details will become clear upon reading the following description referring to the annexed drawings.

### Brief description of the drawings

fig. 1 shows a perspective view of a SOI-FET structure;
fig. 2 shows a vertical section of the structure of fig. 1;
fig. 3 shows a graph of measurements to the structure of fig. 1;
fig. 4 shows a graph of measurements to the structure of fig. 1 at another temperature;
fig. 5 shows a circuit diagram of the structure of fig. 1;
fig. 6 shows another circuit diagram employing the semiconductor structure of fig. 1;
fig. 7 shows another circuit diagram employing the semiconductor structure of fig. 1;
fig. 8 shows another circuit diagram employing the semiconductor structure of fig. 1; and

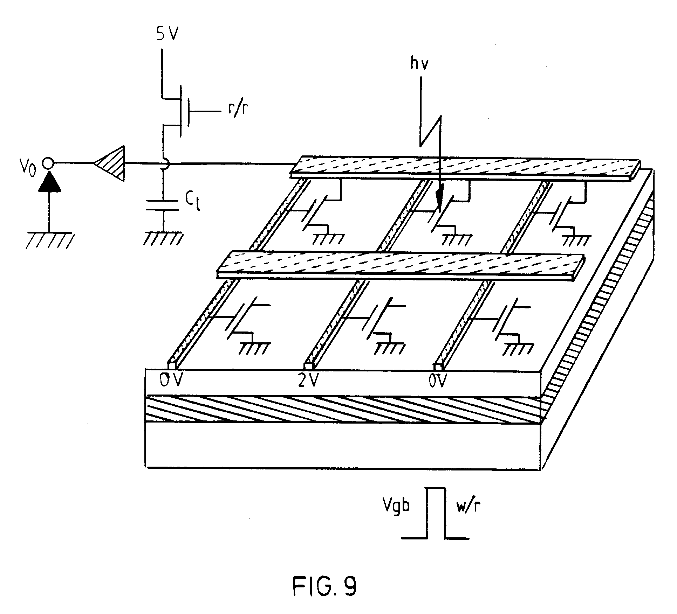

fig. 9 shows a perspective, partly schematic view of the structure of fig. 1 used as radiation detector.

### Detailed description of the drawings

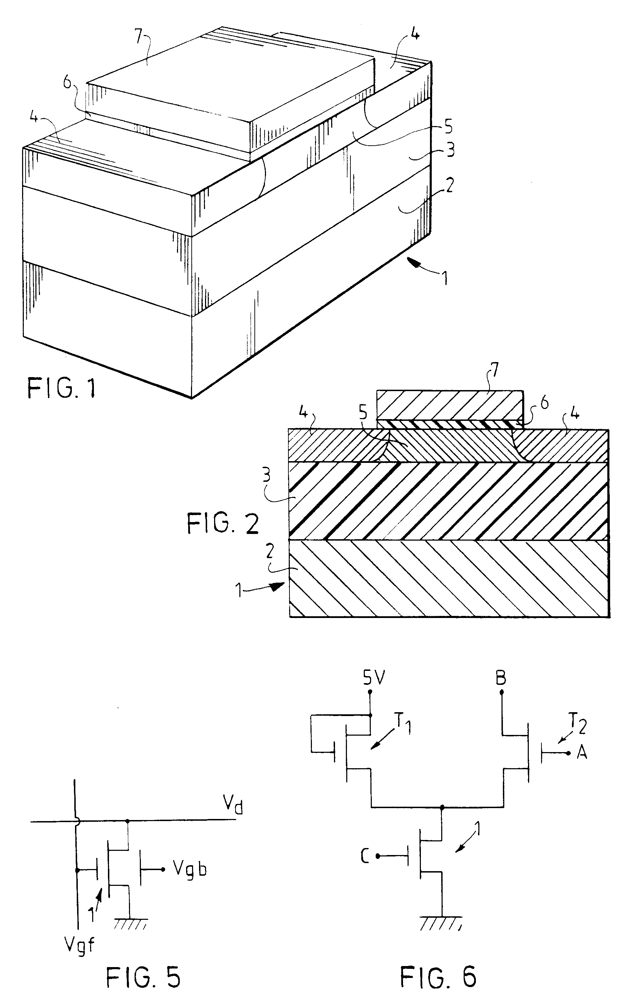

A SOI-structure 1 (fig. 1 and 2) comprises a backgate 2, an insulating layer 3 and a N⁺ silicon film 4 provided thereto in which a so-called SOI cavity is included, in which a P⁻ region 5 is provided. A front insulating layer 6 is provided to the Si-layer 4 and the P⁻ region 5, to which layer 6 the front gate 7 is provided. Preferably the backgate 2 comprises silicon, the layer 3 is formed of SiO₂ by means of oxydation and the film 4 is formed by deposition, after which the film is crystallized preferably by a laser.

The value of the current through the cavity region 5, when a voltage is applied laterally thereto, will be dependent on voltages to front and back gate 7, 2 resp.

It is also possible to influence the charge Q_{CAV} in this region 5 in a different way, e.g. by means of laser radiation, impact ionization or tunneling, in this region or in surrounding regions.

According to the present invention such a cavity charge condition is maintained during a certain time period, as such structure is being cooled. Therefore a multistable or bistable condition of the semiconductor structure is obtained, by means of which e.g. a memory effect is to be obtained. The threshold voltage V_{T} of the P-region 5 is adjustable such that the current characteristic of this region is controlable.

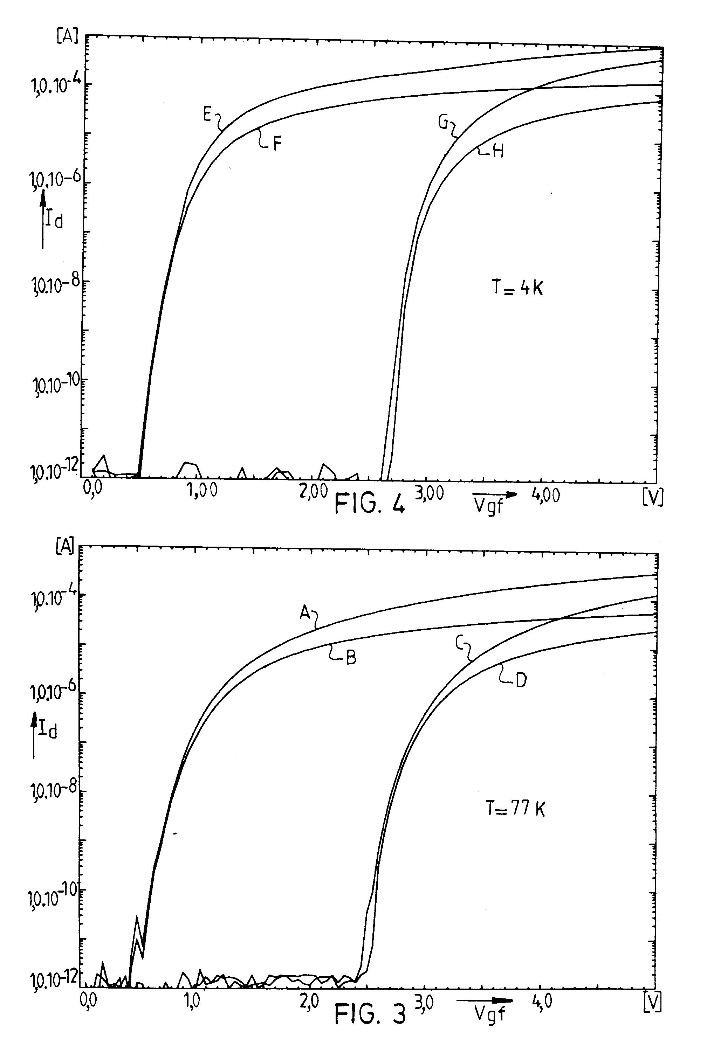

Fig. 3 shows a graph of the drain current I_{d} as function of the voltage to the front gate V_{gf}, in which the SOI-NMOS-structure was held at 77 K. Curves A and C represent the situation in which a voltage of 3.5 Volt was supplied to the P⁻ region 5, while in the situation of curves B and D a voltage of V_{D} is 0.5 Volt was applied. The back gate 2 was pulsed starting from a DC-voltage of -20 Volt to 0, - 40 Volt resp. and vice versa, in which the difference between curves A and B on the one hand and curves C and D on the other hand was obtained. Curves A and B provide a threshold voltage V_{T} of 1.2 Volt, while curves C and D provide a threshold voltage V_{T} of 3 Volt.

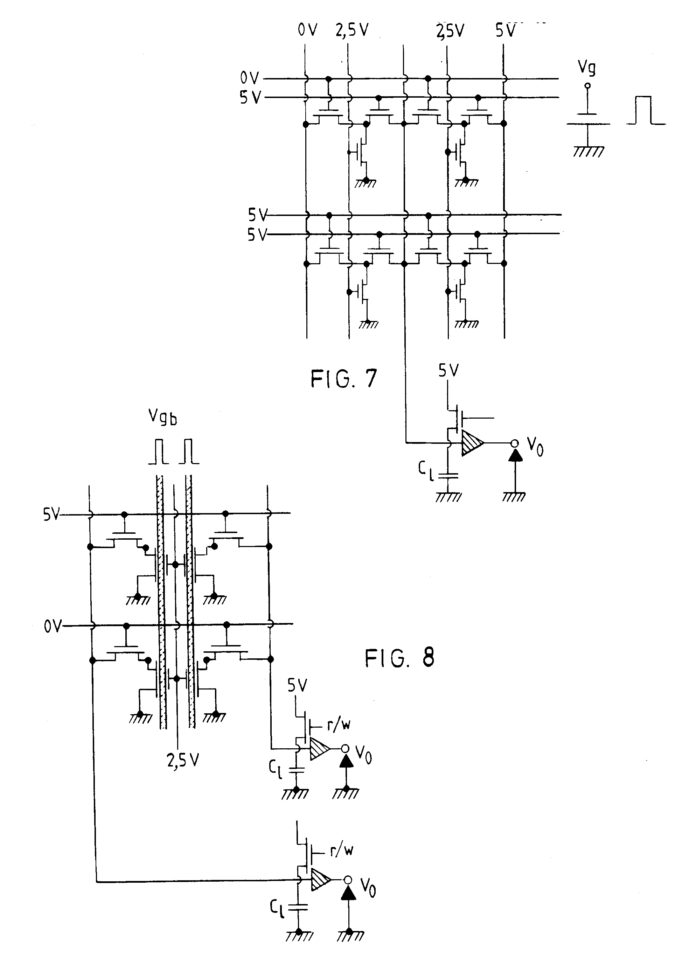

The graph of fig. 5 was obtained by cooling the structure to 4 K. Further, the circumstances for the curves E and F are similar to those for curves A and B and those of curves G and H to those for curves C and D, viz. pulses from -20 Volt to -40 Volt from -20 Volt to 0 Volt, resp.

The pulses bias the junctions between N⁺- and P⁻ region forwardly temporarily, whereby the amount of charge stored in the P⁻ region (cavity) is influenced.

At 77 K the structure still showed thermal degradation effects, meaning that the cavity charge Q_{CAV} was decreased considerably after some time period, while at 4 K such a condition was maintained during more than one hour. When a short pulse V_{gb} of e.g. -20 Volt to 0 Volt to -20 Volt is applied in the circuit diagram of fig. 5, if the element 1 is already in a condition in which V_{T} has a high value, this structure will be confirmed in this condition. For certain values of V_{gf} and suitable V_{d} it is also possible to obtain a condition in which the structure is confirmed in this condition, if the semiconductor element shows a low V_{T} value, e.g. V_{gf}=2 Volt and V_{d}=5 Volt.

In this way the refreshing of such a memory cell 1 is executed, e.g. for ROM-like or EPROM-like application. The semiconductor element 1 according to the present invention is compact and may be driven at high rate.

Fig. 6 shows a circuit diagram in which two transistors T₁ and T₂ are added to the semiconductor 1, which circuit is suited for RAM-like applications. By including terminals A, B and C in a matrix read/write/refresh-signals will be obtained. The desired voltages at terminals A, B and C are dependant on the W/L ratio of the semiconductor structure, as well as those of transistors T₁ and T₂.

A typical embodiment of a SOI-NMOS-transistor comprises e.g. an Si-layer 4 of 500 nm, a back oxide of e.g. 500 nm and a borium concentration of 10¹⁶ cm⁻³. The threshold voltage V_{T} can be influenced in this embodiments through the cavity charge Q_{cav}, as well as through the front gate voltage V_{gb}, which influence can be correlated. Bias voltages and pulse width(s) are dependant on the chosen thickness of the layers.

A transistor operating according to the present invention is hardened to radiation influence.

Each semiconductor element can be controlled (refreshed) through a separate back gate in future three dimensional integrated circuits.

First applications of the present invention will probably in aerospace, in high rate computers and apparatus using superconduction, in which cooling medium is available.

## Claims

1. A method of operating a SOI-FET-structure, including a conducting back gate (2), a back oxide (3) provided thereon, a silicon film (4) provided thereon of one conductivity type provided with a channel region (5) in which semiconductor material of the other conductivity type is provided, an oxide layer (6) provided on said region of the other conductivity type, and a conducting top gate (7) provided on said oxide layer, **characterized by** influencing the amount of charge in the channel region such that the threshold voltage of said FET is adjusted and maintaining such channel charge condition during a certain time period by cooling the SOI-FET-structure such that a multistable operating condition of said FET is obtained.

2. A method according to claim 1, in which the charge is supplied by a voltage, preferably a pulse, to the back gate.

3. A method of claim 1 and 2, in which the voltage to the back gate comprises a pulse.

4. A method of claim 1, 2 or 3, comprising the step of cooling the SOI-FET-structure at a value below room temperature, preferably below 300 K, more preferably at approx. 77 K, on around 4 K or between 4 K and 77 K.

5. A method according to one of the claims 1-4, in which the SOI-FET-structure comprises one or more NMOS-transistors, a DC voltage of -20 Volt being supplied to the back gate, a pulse to 0 Volt, or -40 Volt being superimposed to the DC voltage and in which to the front gate and/or back gate pulses drain to e.g. 5 Volt are supplied.

## Patentansprüche

1. Verfahren zum Betrieb einer SOI-FET-Struktur, die ein leitendes rückseitiges Gate (2), ein darauf angeordnetes rückseitiges Oxyd (3), einen darauf angeordneten Siliziumfilm (4) von einem Leitungstyp, der mit einem Kanalbereich (5) versehen ist, in dem Halbleitermaterial des anderen Leitungstyps vorgesehen ist, eine Oxydschicht (6), die auf dem Bereich des anderen Leitungstyps angeordnet ist, und ein leitendes oberes Gate (7) einschließt, das auf der Oxydschicht angeordnet ist, dadurch gekennzeichnet, daß die Ladungsmenge in dem Kanalbereich derart beeinflußt wird, daß die Schwellenwertspannung des FET eingestellt wird, und daß dieser Kanal-Ladungszustandes während einer bestimmten Zeiterpeiode durch Kühlen der SOI-FET-Struktur derart aufrechterhalten wird, daß ein multistabiler Betriebszustand des FET erzielt wird.

2. Verfahren nach Anspruch 1, bei dem die Ladung durch eine Spannung, vorzugsweise einen Impuls, an das rückseitige Gate geliefert wird.

3. Verfahren nach Anspruch 1 oder 2, bei dem die Spannung an das rückseitige Gate einen Impuls umfaßt.

4. Verfahren nach Anspruch 1, 2 oder 3, das den Schritt der Kühlung der SOI-FET-Struktur auf einen Wert unterhalb der Raumtemperatur, vorzugsweise unterhalb von 300° K und weiter vorzugsweise auf ungefähr 77° K oder ungefähr 4° K oder zwischen 4° K und 77° K umfaßt.

5. Verfahren nach einem der Ansprüche 1 bis 4, bei dem die SOI-FET-Struktur einen oder mehrere NMOS-Transistoren umfaßt, eine Gleichspannung von -20 Volt dem rückseitigen Gate zugeführt wird, ein Impuls von 0 Volt und/oder -40 Volt der Gleichspannung überlagert wird, und bei dem dem vorderen Gate und/oder dem rückseitigen Gate Drain-Impulse von beispielsweise 5 Volt zugeführt werden.

## Revendications

1. Procédé de mise en oeuvre d'une structure SOI-FET, comprenant une électrode de grille arrière conductrice (2), un fond d'oxyde (3) disposé dessus, un film de silicium (4) disposé dessus, d'un certain type de conductivité, pourvu d'une zone du canal (5) dans laquelle le matériau semiconducteur de l'autre type de conductivité est disposé, une couche d'oxyde (6) disposée sur ladite zone de l'autre type de conductivité, et une électrode de grille supérieure conductrice (7) disposée sur ladite couche d'oxyde, caractérisé en ce qu'on influence la quantité de charge dans la zone du canal de façon à ce que la tension de seuil dudit FET soit ajustée et en maintenant un tel état de charge de canal pendant un certain laps de temps en refroidissant la structure SOI-FET, de façon à ce qu'un état de fonctionnement multistable dudit FET soit obtenu.

2. Procédé selon la revendication 1, dans lequel la charge est apportée par une tension, de préférence une impulsion, à l'électrode de grille arrière.

3. Procédé selon les revendications 1 et 2, dans lequel la tension à l'électrode de grille arrière est constituée d'une impulsion.

4. Procédé selon la revendication 1, 2 ou 3, comprenant l'étape de refroidissement de la structure SOI-FET à une température inférieure à la température ambiante, de préférence inférieure à 300 °K, ou encore mieux à approximativement 77 °K, ou aux alentours de 4 °K ou entre 4 °K et 77 °K.

5. Procédé selon l'une des revendications 1 à 4, dans lequel la structure SOI-FET est constituée d'un ou plusieurs transistors NMOS, une tension continue de - 20 volts étant fournie à l'électrode de grille arrière, une impulsion à 0 volt et/ou - 40 volts étant superposée à la tension continue, et dans lequel des impulsions de drain de 5 volts, par exemple, sont appliquées à l'électrode de grille supérieure et/ou arrière.
